Europäisches Patentamt

(19) European Patent Office

Office européen des brevets

(11) **EP 1 234 379 B1**

(12) **EUROPÄISCHE PATENTSCHRIFT**

(45) Veröffentlichungstag und Bekanntmachung des Hinweises auf die Patenterteilung:
**12.10.2005 Patentblatt 2005/41**

(21) Anmeldenummer: **00984884.7**

(22) Anmeldetag: **08.11.2000**

(51) Int Cl.⁷: **H03L 1/02**, H03L 7/02

(86) Internationale Anmeldenummer:
**PCT/DE2000/003926**

(87) Internationale Veröffentlichungsnummer:
**WO 2001/035533 (17.05.2001 Gazette 2001/20)**

(54) **VORRICHTUNG UND VERFAHREN ZUR ERZEUGUNG EINES TAKTSIGNALS**

DEVICE AND METHOD FOR PRODUCTION OF A CLOCK SIGNAL

DISPOSITIF ET PROCEDE POUR PRODUIRE UN SIGNAL D'HORLOGE

(84) Benannte Vertragsstaaten:
**AT BE CH CY DE DK ES FI FR GB GR IE IT LI LU MC NL PT SE TR**

(30) Priorität: **08.11.1999 DE 19953578**

(43) Veröffentlichungstag der Anmeldung:
**28.08.2002 Patentblatt 2002/35**

(73) Patentinhaber: **Mikron Aktiengesellschaft für integrierte Mikroelektronik**
**85399 Hallbergmoos (DE)**

(72) Erfinder: **KURZBAUER, Werner**
**81825 München (DE)**

(74) Vertreter: **Verscht, Thomas Kurt Albert**
**Agnesstrasse 64**
**80797 München (DE)**

(56) Entgegenhaltungen:
**GB-A- 1 412 718**          **US-A- 4 520 327**
**US-A- 5 617 062**

**Beschreibung**

Die vorliegende Erfindung betrifft eine Vorrichtung und ein Verfahren zur Erzeugung eines Taktsignals, d.h. eines Wechselsignals mit konstanter Frequenz, gemäß Patentanspruch 1 bzw. Patentanspruch 7.

Ein derart erzeugtes Signal bietet zum Beispiel vielfältige Einsatzmöglichkeiten in Vorrichtungen bzw. Schaltungen, in denen eine Zeitbasis für bestimmte zeitliche Steuerungen, Regelungen und/oder Messungen erforderlich ist. Eine spezielle Verwendungsmöglichkeit einer solchen Zeitbasis ist der Einsatz in sogenannten intelligenten Akkumulatoren bzw. kurz Akkus. In diesen Akkus ist ein intelligenter Baustein in Form eines Chips integriert, in dem die Vorgeschichte des Akkus, d.h. insbesondere sein aktueller Ladungszustand, seine maximale Ladekapazität, etc. gespeichert werden. Wenn beim Ladevorgang des Akkus dessen Vorgeschichte und Ladeparameter bekannt sind, dann ist eine wesentlich effektivere, d.h. insbesondere schnellere und vollständigere, Wiederaufladung des Akkus möglich.

Zur Erfassung der Vorgeschichte des Akkus benötigt ein solcher Chip eine Zeitbasis, um den zeitlichen Verlauf der Lade- und Entladevorgänge genau erfassen zu können. Als klassische Schaltungen zur Erzeugung eines als Zeitbasis verwendbaren Signals bzw. Taktsignals sind beispielsweise gängige RC-Oszillatoren bekannt, die eine ungedämpfte elektrische Schwingung bestimmter Kurvenform und Frequenz mit konstanter Amplitude erzeugen. Solche RC-Oszillatoren weisen aber einen relativ großen Temperaturkoeffizienten auf, so daß eine hohe Konstanz der Frequenz des Ausgangssignals und damit eine hohe Genauigkeit der entsprechenden Zeitbasis bei Temperaturschwankungen nicht erreicht werden kann, und besitzen eine relativ hohe-Stromaufnahme, was insbesondere bei dem Einsatz in intelligenten Akkus von Nachteil ist. Um die Konstanz bzw. Genauigkeit von RC-Oszillaioren zu erhöhen, werden diese häufig mittels zusätzlicher Schwingkreise abgeglichen.

Eine weitere bekannte Möglichkeit zur Erzeugung einer Zeitbasis ist die Verwendung eines Quarzoszillators. Ein Quarzoszillator zeichnet sich besonders durch seine hohe Frequenzkonstanz und seinen niedrigen Temperaturkoeffizienten aus. Solche Quarzoszillatoren sind aber im allgemeinen relativ teuer und relativ groß. Darüber hinaus ist die hohe Genauigkeit einer durch einen Quarzoszillator erzeugten Zeitbasis bei einigen Anwendungen, wie beispielsweise auch den intelligenten Akkus, nicht unbedingt erforderlich.

Ferner sind im Stand der Technik sogenannte VCO's (voltage controlled oscillator) bekannt. Der VCO ist ein Spannungs-Frequenz-Umsetzer und besteht im wesentlichen aus einem Integrator und einem Trigger. Die Frequenz des Ausgangssignals des VCO ist proportional zur Steuerspannung des VCO. Allerdings weist auch der VCO einen hohen Temperaturkoeffzienten für die Ausgangsfrequenz auf, so daß bei Temperaturschwankungen keine Zeitbasis mit ausreichend hoher Genauigkeit gewährleistet werden kann.

Im Hinblick auf den Stand der Technik wird ferner auf das US-Patent 5,617,062 hingewiesen, aus welchem eine Zeitsteuerungsinitialisierungsschaltung bekannt ist, welche verwendet wird, um ein Zeitsteuerungssignal eines Systems zu stabilisieren, welches unter Verwendung eines Kemoszillators zeitgesteuert wird. Die Zeitsteuerungsinitialisierungsschaltung weist eine Schaltung auf, welche den Kernoszillator während eines Abschaltmodus unwirksam macht und den Kemoszillator erneut wirksam macht, und zwar auf eine Beendigung des Abschaltmodus hin. Die Zeitsteuerungsinitialisierungsschaltung weist ebenfalls eine Schaltung auf, welche eine Anzeige für eine Oszillationsfrequenz speichert, bei welcher die Schaltung unmittelbar vor dem Abschaltmodus betrieben wird.

Ausgehend von dem vorgenannten Stand der Technik, ist es eine Aufgabe der vorliegenden Erfindung, eine Vorrichtung und ein Verfahren zur Erzeugung eines Signals konstanter Frequenz bereitzustellen, bei welchen die oben genannten Nachteile beim Stand der Technik vermieden werden. Insbesondere sollen eine Vorrichtung und ein Verfahren zur Erzeugung eines Signals konstanter Frequenz vorgesehen werden, die bei relativ geringem Raumbedarf und relativ geringer Stromaufnahme eine ausreichend hohe Frequenzkonstanz und einen niedrigen Temperaturkoeffizienten aurweisen.

Gemäß der vorliegenden Erfindung wird diese Aufgabe durch eine Vorrichtung bzw. Schaltung mit den Merkmalen von Patentanspruch 1 und durch ein Verfahren mit den Merkmalen von Patentanspruch 7 gelöst.

Der VCO zur Erzeugung des Taktsignals ist erfindungsgemäß in einer Regelschaltung derart integriert ist, daß die Frequenz seines Ausgangssignals nur durch in der Regelschaltung enthaltene Schaltungselemente mit niedrigem Temperaturkoeffizienten bestimmt ist. Bei diesen Schaltungselementen handelt es sich vorzugsweise um eine externe Stromquelle und eine Kapazität, die wechselweise mit der Frequenz des Taktsignals mit einer Integratorschaltung verbunden werden, deren Ausgangssignal dem VCO zugeführt wird.

Besondere vorteilhafte Ausgestaltungen und Weiterbildungen der vorliegenden Erfindung sind Gegenstand weiterer Unteransprüche.

Die Erfindung, sowie weitere Ziele, Merkmale, Vorteile und Anwendungsmöglichkeiten derselben wird bzw. werden nachfolgend anhand der beigefügten Zeichnungen näher erläutert. Dabei bilden alle beschriebenen und/oder bildlich dargestellten Merkmale für sich oder in beliebiger sinnvoller Kombination den Gegenstand der vorliegenden Erfindung, und zwar unabhängig von ihrer Zusammenfassung in den Ansprüchen oder deren Rückbeziehung. In den Zeichnungen zeigen:

Fig. 1        ein Blockschaltbild zur Erläuterung des der vorliegenden Erfindung zugrunde liegenden Prinzips;

Fig. 2        den Schaltungsaufbau eines bevorzugten Ausführungsbeispiels, an welchem die Funktionsweise der vorliegenden Erfindung getestet wurde; und

Fig. 3(a) bis 3(e)    verschiedene Signalverläufe zur Erläuterung der Funktionsweise der in Fig. 2 gezeigten Schaltung, wobei den einzelnen Darstellungen jeweils unterschiedliche Offsets bzw. Skalierungen zugrundeliegen.

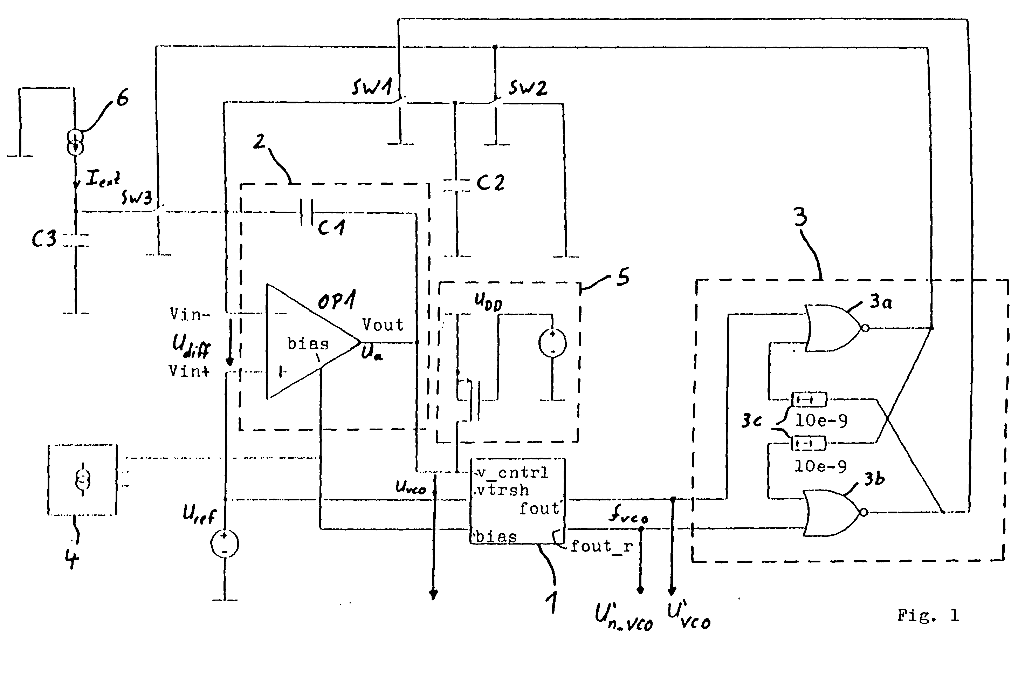

Anhand von Fig. 1 wird zunächst das der vorliegenden Erfindung zugrundeliegende Prinzip beschrieben.

Die Schaltung zur Erzeugung eines Taktsignals bzw. eines Signals konstanter Frequenz, das beispielsweise als Zeitbasis genutzt werden kann, weist im wesentlichen einen VCO (voltage controlled oscillator) 1, einen Integrator 2 und eine Regelschaltung auf.

Der Integrator 2 der Schaltung von Fig. 1 ist in an sich bekannter Weise aufgebaut. Der Integrator 2 weist im wesentlichen einen Operationsverstärker OP1 und eine parallel zu diesem geschaltete Kapazität C1 auf. Die Ausgangsspannung $U_a$ eines solchen Integrators 2 ist (zumindest unter der Annahme, daß die unten beschriebene Regelschaltung nicht vorhanden ist) bekanntermaßen proportional zum negativen Zeitintegral der Eingangsspannungsdifferenz $U_{diff}$ des Integrators.

Der Eingang (v_cntrl) des VCO 1 ist mit dem Ausgang des Integrators 2 verbunden, während der andere Eingang (vtrsh) des VCO 1 mit dem Pluspol der Referenzspannungsquelle $U_{ref}$ verbunden ist. Der VCO 1 ist ein Spannungs-Frequenz-Umsetzer, der eine am Eingang anliegende (Gleich-)Spannung Uvco in ein oszillierendes Ausgangssignal umsetzt. Ein VCO enthält beispielsweise eine Grundschaltung aus einem Integrator und einem Trigger, wobei der Integrator über einen zwischengeschalteten Polaritätswender in Form eines Operationsverstärkers angesteuert wird. Die Frequenz fvco des Ausgangssignals $U'_{VCO}$ des VCO ist proportional zur Eingangs- bzw. Steuerspannung $U_{VCO}$ des VCO I, und das oszillierende Ausgangssignal kann dann zum Beispiel zur Verwendung als Zeitbasis abgegriffen werden. Vorzugsweise liegt die vom Integrator 2 zugeführte Spannung $U_a$ am Eingang des VCO 1 derart an, daß am VCO 1 eine Eingangs- bzw. Steuerspannung Uvco anliegt und bei einer betragsmäßig höheren Eingangsspannung die Frequenz fvco des Ausgangssignals niedriger wird. Die Steigung der entsprechenden Kennlinie ist also negativ.

Die Funktion des VCO 1 ist üblicherweise relativ stark temperaturabhängig, d.h. die Frequenz $f_{VCO}$ des Ausgangssignal kann bei Temperaturschwankungen starken Schwankungen unterliegen, was selbstverständlich im allgemeinen nicht erwünscht ist. Um diese Schwankungen zu vermeiden sind der Integrator 2 und der VCO 1 in einer Regelschaltung integriert, d.h. das Ausgangssignal des VCO 1 wird auf spezielle Weise dem Integrator 2 und damit dem VCO 1 zurückgeführt.

Die in Fig. 1 gezeigte Regelschaltung umfaßt ein logisches Netzwerk 3, zwei von diesem Netzwerk 3 angesteuerte Schalter SW1 und SW2, eine Kapazität C2, eine externe Stromquelle 6, eine Kapazität C3 und einen dritten, ebenfalls vom logischen Netzwerk 3 angesteuerten Schalter SW3.

Der positive Eingang des Integrators 2 ist mit einer Konstantspannungsquelle verbunden, so daß an diesem Eingang eine konstante Referenzspannung $U_{ref}$ anliegt. Der negative Eingang des Integrators 2 ist sowohl mit der externen Stromquelle 6 als auch mit der Kapazität C2 verbunden, die zueinander parallel geschaltet sind. In der Verbindungsleitung zu der Kapazität C2 ist ein erster Schalter SW1 geschaltet. Weiter ist parallel zu der Kapazität C2 ein zweiter Schalter SW2 geschaltet. In der Verbindungsleitung zu der externen Stromquelle 6 ist ein dritter Schalter SW3 geschaltet.

Die drei Schalter SW 1, SW2 und SW3 werden mit der Ausgangsfrequenz $f_{VCO}$ des VCO 1 wechselweise geschaltet, wobei die beiden Schalter SW2 und SW3 parallel im Wechsel mit dem Schalter SW1 gesteuert werden. Die Ansteuerung erfolgt dabei mittels des logischen Netzwerks 3 derart, daß jeweils nur einer der Schalter SW 1 und SW2 geöffnet ist, während der jeweils andere Schalter geschlossen ist. Dabei ist eine Sicherheitsphase derart vorgesehen, daß der jeweils geöffnete Schalter erst eine vorbestimmte Zeit nach dem Öffnen des zuvor geschlossenen Schalters geschlossen wird, so daß sichergestellt ist, daß niemals beide Schalter SW1 und SW2 gleichzeitig geschlossen sind.

Zum Zwecke dieser Ansteuerung weist das in Fig. 1 beispielhaft dargestellte logische Netzwerk 3 zwei NOR-Gatter 3a, 3b auf, die, wie in Fig. 1 gezeigt, miteinander verbunden sind. Zur Erzielung der oben genannten Sicherheitsphase sind die Ausgänge der beiden NOR-Gatter 3a und 3b jeweils über ein Zeitverzögerungsglied 3c, welches den letzten Zustand für eine vorbestimmte Zeit zwischenspeichert, auf einen Eingang des jeweils anderen NOR-Gatters 3a, 3b zurückgeführt. Anstelle des in Fig. 1 gezeigten logischen Netzwerks 3 sind selbstverständlich auch andere logische Netzwerke mit anderen logischen Schaltungsblöcken für die erfindungsgemäße Regelschaltung einsetzbar. Der Fachmann auf dem Gebiet der Schaltungstechnik wird problemlos ein für seine Zwecke geeignetes logisches Netzwerk auswählen bzw. aufbauen.

Nachfolgend wird kurz die Funktionsweise des in Fig. 1 dargestellten logischen Netzwerks 3 beschrieben.

Es sei zunächst angenommen, das der Pegel des Ausgangssignals U'vco des VCO 1 hoch (H) ist, d.h. das invertierte Ausgangssignal $U'_{n\_VCO}$ des VCO 1 niedrig (L) ist, und daß der Schalter SW1 geschlossen (1) und der Schalter SW2 offen (0) ist. Dies bedeutet gleichermaßen, daß der Ausgang des den ersten Schalter SW1 ansteuernden unteren NOR-Gatters 3b auf hohem Pegel (H) und der Ausgang des den zweiten Schalter SW2 ansteuernden oberen NOR-Gatters 3a auf niedrigem Pegel (L) ist. Durch die kreuzweise Rückführung der Ausgangssignale der beiden NOR-Gatter 3a, 3b liegt in dieser Phase an beiden Eingängen des oberen NOR-Gatters 3a ein Signal mit hohem Pegel (H) und an beiden Eingängen des unteren NOR-Gatters 3b ein Signal mit niedrigem Pegel (L).

Nun wechselt das Ausgangssignal U'vco des VCO 1 entsprechend der Frequenz $f_{VCO}$ auf den niedrigen Pegel (L), d.h. das invertierte Ausgangssignal $U'_{n\_VCO}$ des VCO 1 auf den hohen Pegel (H). Demzufolge liegt nun der untere Eingang des NOR-Gatters 3b auf H, und der obere Eingang des NOR-Gatters 3b liegt entsprechend des in der vorigen Schaltphase geöffneten Schalters SW2 bzw. des auf L liegenden Ausgangs des oberen NOR-Gatters 3a auf L. Demzufolge gibt das untere NOR-Gatter 3b ein Ausgangssignal mit niedrigem Pegel (L) aus und der Schalter SW1 wird geöffnet (0). Gleichzeitig liegt der obere Eingang des oberen NOR-Gatters 3a auf L, und der untere Eingang des NOR-Gatters 3a liegt entsprechend des in der vorigen Schaltphase geschlossenen Schalters SW 1 bzw. des auf H liegenden Ausgangs des unteren NOR-Gatters 3b auf H. Demzufolge liegt der Ausgang des oberen NOR-Gatters 3a zunächst weiter auf L und der Schalter SW2 bleibt geöffnet (0). Dies bedeutet, daß bei dem Wechsel des Ausgangssignals $U'_{VCO}$ des VCO 1 von H auf L zunächst beide Schalter SW1 und SW2 geöffnet sind. Erst durch das Öffnen des Schalters SW1 aufgrund des L-Ausgangs des unteren NOR-Gatters 3b liegt, mit einer gewissen Zeitverzögerung aufgrund des Zeitverzögerungsgliedes 3c, auch der untere Eingang des oberen NOR-Gatters 3a auf L, so daß der Ausgang des oberen NOR-Gatters 3a dann auf H wechselt und der Schalter SW2 geschlossen (1) wird.

Anschließend wechselt der Ausgang U'vco des VCO 1 wieder auf H, so daß analog zur obigen Erläuterung der Schalter SW2 geöffnet und mit einer gewissen Zeitverzögerung dazu der Schalter SW1 geschlossen wird. Insgesamt erfolgt die wechselweise Ansteuerung der beiden Schalter SW1 und SW2 mit der Frequenz $f_{VCO}$ des Ausgangssignals $U'_{VCO}$ bzw. $U'_{n\_VCO}$ des VCO 1.

Anstelle der Verwendung eines VCO 1 mit einem invertierten Ausgang ($U'_{n\_VCO}$) kann ebenso ein VCO 1 eingesetzt werden, der nur das "normale" Ausgangssignal $U'_{VCO}$ ausgibt. In diesem Fall wird dem unteren Eingang des unteren NOR-Gatters 3b als Bestandteil des logischen Netzwerks 3 ein Inverter vorgeschaltet.

Nachfolgend wird nun der Aufbau und die Funktionsweise der Regelschaltung von Fig. 1 unter der Annahme näher beschrieben, daß sich die Regelschaltung bereits im eingeschwungenen Zustand befindet, um das Grundprinzip der vorliegenden Erfindung zu erlautern.

Die insgesamt drei Schalter SW1, SW2, SW3 werden von dem logischen Netzwerk 3 derart angesteuert, daß die Schalter SW1 und SW2 wechselweise geöffnet und geschlossen werden und die Schalter SW2 und SW3 zeitgleich geöffnet und geschlossen werden, wobei beim Schließen der Schalter jeweils eine Zeitverzögerung vorgesehen ist, wie oben beschrieben, um Kurzschlüsse in der Regelschaltung auszuschließen.

Die externe Stromquelle 6 enthält einen Widerstand $R_{ext}$ mit einem möglichst niedrigen Temperaturkoeffizienten. Ist der Schalter SW3 geöffnet, so ist die Stromquelle 6 von der ubrigen Regelschaltung getrennt und es wird von der Stromquelle 6 die dritte Kapazität C3 aufgeladen, die als Zwischenspeicher dient. Wird in der nächsten Schaltungsphase der Schalter SW3 geschlossen und gleichzeitig der erste Schalter SW1 geöffnet, so wird die Kapazität C 1 des Integrators 2 durch die Stromquelle 6 und die Kapazität C3 aufgeladen.

Die Kapazität C1 wird dabei während einer Halbperiode der Frequenz des Regelkreises auf eine Ladung aufgeladen, die gleich derjenigen ist, die bei einem ständig geschlossenen Schalter SW3 während einer Vollperiode T transportiert worden wäre, da die Halbperiode des geöffneten Schalters SW3 durch die Pufferkapazität C3 ausgeglichen wird. Ferner ist im eingeschwungenen Zustand des Regelkreises die Eingangsspannung $U_{diff}$ am Operationsverstärker OP1 des Integrators 2 auf $U_{diff}$ = 0 Volt geregelt, so daß am negativen Eingang der Integratorschaltung 2 das Potential $U_{ref}$ anliegt, das auch am positiven Eingang anliegt. Somit fließt während des geschlossenen Schalters SW3 insgesamt ein Strom I durch die Kapazität C 1 und lädt diese auf die Ladung

$$Q_{in} = T \cdot I = T \cdot U_{ref} / R_{ext} \tag{1}$$

auf Die Kapazität C3 stellt sicher, daß trotz der zeitweiligen Trennung der externen Stromquelle 6 von der Regelschaltung während einer ganzen Schwingungsphase T der Regelschaltung die Kapazität C1 nach wie vor mit der gesamten Ladung gemäß Gleichung (1) aufgeladen wird.

Wird anschließend der dritte Schalter SW3 geöffnet und der erste Schalter geschlossen, so wird eine Verbindung der Integratorschaltung 2 mit der Kapazität C2 hergestellt. Sodann wird die Ladung Q zu der Kapazität C2 transportiert und diese aufgeladen. Die Kapazität C2 nimmt in dieser Phase insgesamt das Ladungspaket Q = $U_{ref}$.

C2 auf.

In der nachfolgenden Phase, in der der erste Schalter SW1 geöffnet ist und die beiden Schalter SW2 und SW3 geschlossen sind, wird einerseits, wie oben beschrieben, die Kapazität C 1 über die externe Stromquelle 6 und die Pufferkapazität C3 aufgeladen, und andererseits gibt die Kapazität C2 das Ladungspaket

$$Q_{out} = Q = U_{ref} \cdot C2 \qquad\qquad (2)$$

ab, da beide Anschlüsse der Kapazität C2 mit Masse verbunden sind, d.h. auf dem gleichen Potential liegen, und sich die Kapazität somit entlädt. Im Gleichgewicht müssen die beiden Ladungspakete $Q_{in}$ und $Q_{out}$ gleich groß sein, so daß die beiden Gleichungen (1) und (2) gleichzusetzen sind. Mit fvco = 1 / T ergibt sich dann:

$$f_{VCO} = 1 / T = 1 / (R_{ext} \cdot C2) \qquad\qquad (3)$$

Im eingeschwungenen Zustand der Regelschaltung von Fig. 1 ist somit die Frequenz $f_{VCO}$ des Ausgangssignals $U'_{VCO}$ bzw. $U'_{n\_VCO}$ des VCO 1 unabhängig vom Temperaturkoeffizienten des VCO1, sondern nur abhängig von den beiden Größen $R_{ext}$ und C2 des Regelkreises, die aber einen sehr niedrigen Temperaturkoeffizienten besitzen. Aus diesem Grunde ist die Ausgangsfrequenz des VCO 1 sehr temperaturstabil und kann deshalb als sehr genaue Zeitbasis genutzt werden.

In der Praxis muß darauf geachtet werden, daß die Geschwindigkeit des Operationsverstärkers OP1 groß genug ist, um ein vollständiges Laden der Kapazität C2 in einer halben Schwingungsperiode der Regelschaltung, also beispielsweise innerhalb von 1 μsec, zu gewährleisten.

Weiterhin ist in der Schaltung von Fig. 1 eine Vorspannungserzeugungsschaltung 4 (Bias) vorgesehen, die sowohl als Vorspannquelle mit dem Operationsverstärker als auch mit dem VCO 1 verbunden ist.

Ferner ist der Eingang des VCO 1 zur Inbetriebnahme der Schaltung auf ein Potential $U_{DD}$ gelegt. um ein "Weglaufen" der Kapazitäten zu verhindern. Zu diesem Zweck ist eine POC-Schaltung 5 (power on control) vorgesehen. Außerdem muß zu Beginn die Integratorschaltung 2 mit der externen Stromquelle 6 verbunden sein, um das System zu starten. Alternativ kann der VCO 1 auch mit einer "Offset-Frequenz" betrieben werden, um das System zu starten.

Um zu Beginn der Inbetriebnahme einen definierten Schaltungszustand des logischen Netzwerks 3 und der Schalter SW1, SW2 und SW3 zu erhalten, müssen die Zeitverzögerungsglieder 3c des logischen Netzwerkes 3 eine asynchrone Grundeinstellung (Reset) aufweisen.

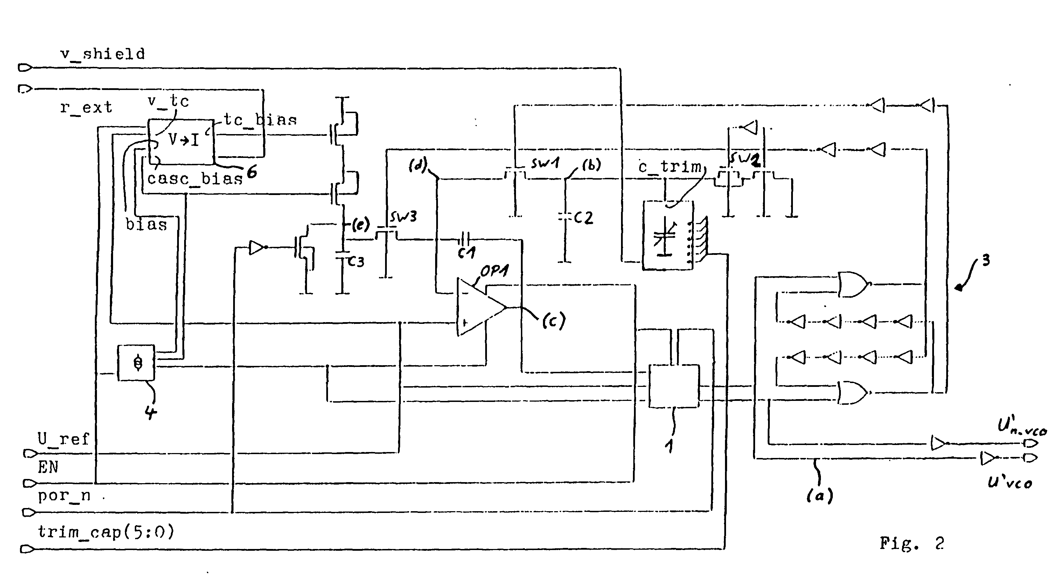

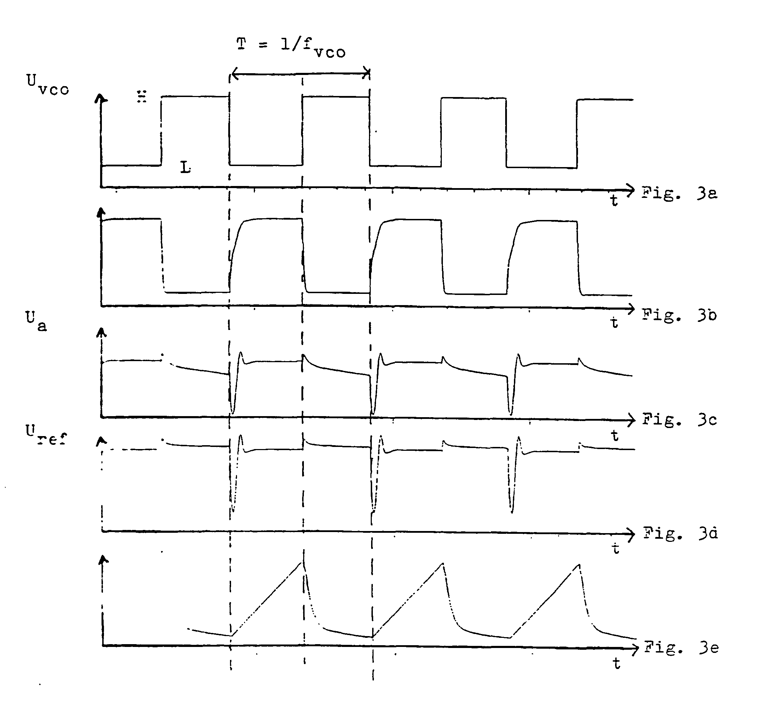

Zur weiteren Erläuterung der Funktionsweise der Erfindung werden nachfolgend ein bevorzugter Schaltungsaufbau gemäß Fig. 2, an der die Erfindung getestet worden ist, und mehrere an verschiedenen Punkten der Schaltung von Fig. 2 aufgezeichnete Signalverläufe anhand der Fig. 3(a) bis 3(e) beschrieben.

Der Schaltungsaufbau von Fig.2 enthält ebenfalls die in Fig. 1 gezeigten Bauteile, nämlich einen VCO 1, eine Integratorschaltung 2 mit Operationsverstärker OP1 und Kapazität C1, ein logisches Netzwerk 3, vom logischen Netzwerk 3 angesteuerte Schalter SW1, SW2 und SW3, eine zweite Kapazität C2, eine externe Stromquelle 6 mit einem Widerstand $R_{ext}$ mit niedrigem Temperaturkoeffizienten und eine Pufferkapazität C3 für die externe Stromquelle 6.

Als Kapazitäten wurden beispielsweise Kondensatoren mit Kapazitätswerten von C1 = 10 pF, C2 = 730 fF und C3 = 10 pF eingesetzt. Die Zeitverzögerungsglieder 3c des logischen Netzwerks 3 sind jeweils durch eine geradzahlige Anzahl von Invertern realisiert. Als Schalter SW1, SW2, SW3 können übliche Transistoren eingesetzt werden.

Mit der in Fig. 2 gezeigten Schaltung zur Erzeugung eines Taktsignals kann beispielsweise ein Taktsignal mit einer Frequenz fvco von 500 kHz erzeugt werden. Aufgrund des erfindungsgemäßen Regelkreises ist eine Abweichung der Frequenz $f_{VCO}$ von weniger als 1% bei einem Temperaturunterschied von etwa 100°C erreichbar.

In der in Fig. 2 gezeigten Schaltung wurden an den mit (a), (b), (c), (d) und (e) gekennzeichneten Stellen die Signalverläufe der an diesen Stellen vorherrschenden Potentiale gemessen. Die Ergebnisse dieser Messungen sind in den Fig. 3(a), 3(b), 3(c), 3(d) bzw. 3(e) dargestellt.

Fig. 3(a) zeigt den Potentialverlauf des Ausgangssignals U'vco des VCO 1. Das Ausgangssignal $U'_{VCO}$ weist eine konstante Frequenz fvco bzw. eine konstante Periode T = $1/f_{VCO}$ auf. Wie oben beschrieben, ist während der Halbperiode, in der das Ausgangssignal U'vco auf hohem Pegel (H) ist, der Schalter SW1 geschlossen, und während der Halbperiode, in der das Ausgangssignal U'vco auf niedrigem Pegel (L) ist, sind die Schalter SW2 und SW3 geschlossen. Wie in Fig. 3(b) gezeigt, entlädt sich die Kapazität C2 während der Halbperiode, in der der Schalter SW2 geschlossen ist, d.h. das Ausgangssignal $U'_{VCO}$ auf niedrigem Pegel (L) liegt.

In Fig. 3(c) ist das Ausgangssignal $U_a$ der Integratorschaltung 2 gezeigt, welches dem VCO 1 als Steuersignal an den negativen Eingang (v_cntrl) zugeführt wird. In Fig. 3(d) ist der zeitliche Verlauf des Potentials dargestellt, welches am negativen Eingang der Integratorschaltung 2 bzw. des Operationsverstärkers OP1 der Integratorschaltung 2 vorherrscht. Die Integratorschaltung 2 steuert den Operationsverstärker OP1 derart, daß dessen Eingangsdifferenzspannung $U_{diff}$ auf 0 geregelt wird, d.h. daß das Potential am negativen Eingang des Operationsverstärkers OP1 wie das Potential am positiven Eingang des Operationsverstärkers OP1 im wesentlichen auf dem Potential Uref liegt.

Fig. 3(e) stellt den Verlauf der Aufladung der Kapazität C1 durch die externe Stromquelle 6 und die Pufferkapazität C3 dar. Während der Halbperiode, in der das Ausgangssignal $U'_{VCO}$ des VCO auf hohem Pegel (H) liegt, ist der dritte Schalter SW3 geöffnet und die externe Stromquelle 6 lädt die Kapazität C3 auf. In der nachfolgenden Halbperiode, in der das Ausgangssignal U'vco des VCO 1 auf niedrigem Pegel (L) liegt, ist der dritte Schalter SW3 geschlossen und die Kapazität C1 der Integratorschaltung 2 wird durch die externe Stromquelle 6 sowie die in der Kapazität C3 zwischengespeicherte Ladung aufgeladen.

Die Erfindung wurde zuvor anhand eines bevorzugten Ausführungsbeispiels näher erläutert. Für einen Fachmann ist es jedoch offensichtlich, daß verschiedene Abwandlungen und Modifikationen gemacht werden können, ohne den der Erfindung zugrundeliegenden Gedanken zu verlassen. Dabei ist ein wesentlicher Aspekt der Erfindung die Umgehung der inhärenten Temperaturabhängigkeit eines VCO durch Einbindung desselben in eine die Ausgangsfrequenz bestimmende Schleifenschaltung. Auf diese Weise läßt sich eine Zeitbasis kostengünstig realisieren.

Die Erfindung läßt sich folgendermaßen zusammenfassen:

A. Vorrichtung zur Erzeugung eines Signals konstanter Frequenz, mit einem VCO (1), an dessen Ausgang ein Signal konstanter Frequenz ($f_{VCO}$) abgreifbar ist, wobei der VCO (1) in einer Regelschaltung derart integriert ist, daß die Frequenz ($f_{VCO}$) des Ausgangssignals des VCO (1) nur durch in der Regelschaltung enthaltene Schaltungselemente ($C2$, $R_{ext}$) mit niedrigem Temperaturkoeffizienten bestimmt ist.

B. Vorrichtung nach Punkt A, wobei der Eingang des VCO (1) mit dem Ausgang einer Integratorschaltung (2) verbunden ist.

C. Vorrichtung nach Punkt B, wobei der Eingang des VCO (1) mit dem Ausgang der Integratorschaltung (2) derart verbunden ist, daß eine Erhöhung des Ausgangssignals ($U_a$) der Integratorschaltung (2) eine Erniedrigung der Frequenz ($f_{VCO}$) des Ausgangssignals ($U'_{VCO}$) des VCO (1) bewirkt.

D. Vorrichtung nach Punkt B oder C, wobei der Eingang der Integratorschaltung (2) mit einer Parallelschaltung aus einer externen Stromquelle (6, $R_{ext}$) und einer Kapazität (C2) verbunden ist, die wechselweise mit der Frequenz ($f_{VCO}$) des Ausgangssignals ($U'_{VCO}$) von der integratorschaltung (2) getrennt werden.

E. Vorrichtung nach Punkt D, der Ausgang des VCO (1) mit einem logischen Netzwerk (3) verbunden ist, welches zur Steuerung der Regelschaltung mit Schaltern (SW1, SW3) verbunden ist, welche die externe Stromquelle (6) bzw, die Kapazität (C2) von der Integratorschaltung trennen.

F. Vorrichtung nach Punkt D oder E, die Kapazität (C2) einerseits über den einen Schalter (SW1) mit der Integratorschaltung (2) und andererseits über einen weiteren Schalter (SW2) zum Entladen mit Masse verbunden ist, wobei die Schalter (SW1, SW2) wechselweise geöffnet und geschlossen werden.

G. Vorrichtung nach Punkt F, der die Kapazität (C2) mit Masse verbindende Schalter (SW2) ebenfalls mittels des logischen Netzwerks (3) angesteuert wird.

H. Verfahren zur Erzeugung eines Signals konstanter Frequenz mittels eines VCO (1), an dessen Ausgang ein Signal konstanter Frequenz ($f_{VCO}$) abgreifbar ist, die Frequenz ($f_{VCO}$) nur von Schaltungselementen ($C2$, $R_{ext}$) mit niedrigem Temperaturkoeffizienten bestimmt wird, die in einer den VCO (1) enthaltenden Regelschaltung vorhanden sind.

I. Verfahren nach Punkt H, dem Eingang des VCO (1) das Ausgangssignal ($U_a$) einer Integratorschaltung (2) zugeführt wird.

J. Verfahren nach Punkt I, dem Eingang des VCO (1) das Ausgangssignal ($U_a$) der Integratorschaltung (2) derart zugeführt wird, daß eine Erhöhung des Ausgangssignals ($U_a$) der Integratorschaltung (2) eine Erniedrigung der Frequenz ($f_{VCO}$) des Ausgangssignals ($U'_{VCO}$) des VCO (1) bewirkt.

K. Verfahren nach Punkt I oder J. der Eingang der Integratorschaltung (2) wechselweise mit der Frequenz ($f_{VCO}$) des Ausgangssignals ($U'_{VCO}$) mit einer externen Stromquelle (6) und mit einer Kapazität (C2) verbunden wird.

L. Verfahren nach Punkt K, wobei die wechselweise Trennung der Integratorschaltung (2) von der externen Stromquelle (6) und der Kapazität (C2) mittels eines logischen Netzwerks (3) erfolgt, welchem das Ausgangssignal (U'$_{VCO}$) des VCO (1) zugeführt wird.

M. Verwendung der Vorrichtung nach einem der Punkte A bis G zur Erzeugung einer Zeitbasis.

N. Verwendung nach Punkt M, wobei die Zeitbasis in einem intelligenten Akku verwendet wird.

**Patentansprüche**

1. Schaltungsanordnung zur Erzeugung eines Ansgangssignals konstanter Frequenz, welche folgendes aufweist:

   - einen regelbaren Oszillator,

   **dadurch gekennzeichnet, daß** die Schaltungsanordnung ferner eine Integrator schaltung (2) aufweist, wobei die Integratorschaltung(2) einen Operationverstärker (OP1) und eine parallel zu diesem geschaltete Kapazität (C1) aufweist, daß die Integrator schaltung (2) zur Integration eines Eingangsstroms vorgesehen ist daß die Integrator schaltung (2) als Ladungsspeicher dient, daß die Ausgangsgröße der Integratorschaltung (2) als Eingangsgröße für den regelbaren Oszillator vorgesehen ist, wobei
   der Eingang des regelbarenoszillators mit dem Ausgang der Integratorschaltung (2) verbunden ist,
   daß mit der Ausgangsfrequenz des regelbaren Oszillators definierte Ladungspakete vom Ladungsspeicher abgezogen werden, und
   daß der Eingang der Integratorschaltung (2) mit einer Parallelschaltung aus einer externen Stromquelle (6, R$_{ext}$) und einer weiteren Kapazität (C2) verbunden ist, die über einen Schalter (SW3) mit der Frequenz (f$_{VCO}$) des Ausgangssignals (U'$_{VCO}$) von der Integratorschaltung (2) getrennt werden.

2. Schaltungsanordnung nach Anspruch 1, **dadurch gekennzeichnet, daß** die Schaltungsanordnung als regelbaren Oszillator einen VCO (1) aufweist, an dessen Ausgang das Ausgangssignal konstanter Frequenz (fvco) abgreifbar ist, und daß der VCO (1) in einer Regelschaltung derart integriert ist, daß die Frequenz (fvco) des Ausgangssignals des VCO (1) nur durch in der Regelschaltung enthaltene Schaltungselemente (C2, R$_{ext}$) mit niedrigem Temperaturkoeffizienten bestimmt ist.

3. Schaltungsanordnung nach Anspruch 2, **dadurch gekennzeichnet, daß** der Eingang des VCO (1) mit dem Ausgang der Integratorschaltung (2) derart verbunden ist, daß eine Erhöhung des Ausgangsgröße (U$_a$) der Integratorschaltung (2) eine Erniedrigung der Frequenz (f$_{VCO}$) des Ausgangssignals (U'$_{VCO}$) des VCO (1) bewirkt.

4. Schaltungsanordnung nach Anspruch 2 oder 3, **dadurch gekennzeichnet, daß** der Ausgang des VCO (1) mit einem logischen Netzwerk (3) verbunden ist, welches zur Steuerung der Regelschaltung mit Schaltern (SW1, SW3) verbünden ist, welche die externe Stromquelle (6) bzw. die weitere Kapazität (C2) von der Integratorschaltung (2) trennen.

5. Schaltungsanordnung nach einem der Ansprüche 1 bis 4, **dadurch gekennzeichnet, daß** die weitere Kapazität (C2) einerseits über einen Schalter (SW1) mit der Integratorschaltung (2) und andererseits über einen weiteren Schalter (SW2) zum Entladen mit Masse verbunden ist, wobei die Schalter (SW1, SW2) wechselweise geöffnet und geschlossen werden.

6. Schaltungsanordnung nach Anspruch 5, **dadurch gekennzeichnet, daß** der die weiter Kapazität (C2) mit Masse verbindende Schalter (SW2) ebenfalls mittels des logischen Netzwerks (3) angesteuert wird.

7. Verfahren zur Erzeugung des Ausgangssignals konstanter Frequenz mit einer Schaltungsanordnung nach einem der Ansprüche 1 bis 6.

8. Verfahren nach Anspruch 7, **dadurch gekennzeichnet, daß** als regelbarer Oszillator der VCO (1), an dessen Ausgang das Ausgangssignal konstanter Frequenz (f$_{VCO}$) abgreifbar ist, eingesetzt wird, und daß die Frequenz (f$_{VCO}$) nur von Schaltungselementen (C2, R$_{ext}$) mit niedrigem Temperaturkoeffizienten bestimmt wird, die in einer den VCO (1) enthaltenden Regelschaltung vorhanden sind.

9. Verfahren nach Anspruch 8, **dadurch gekennzeichnet, daß** dem Eingang des VCO (1) die Ausgangsgröße ($U_a$) der Integratorschaltung (2) zugeführt wird.

10. Verfahren nach Anspruch 9, **dadurch gekennzeichnet, daß** dem Eingang des VCO (1) die Ausgangsgröße ($U_a$) der Integratorschalrung (2) derart zugeführt wird, daß eine Erhöhung der Ausgangsgröße ($U_a$) der Integratorschaltung (2) eine Erniedrigung der Frequenz ($f_{VCO}$) des Ausgangssignals ($U'_{VCO}$) des VCO (1) bewirkt.

11. Verfahren nach einem der Ansprüche 1-10, **dadurch gekennzeichnet, daß** die Trennung der Integratorschaltung (2) von der externen Stromquelle (6) und der weiteren Kapazität (C2) mittels eines logischen Netzwerks (3) erfolgt, welchem das Ausgangssignal ($U'_{VCO}$) des VCO (1) zugeführt wird.

12. Verwendung der Schaltungsanordung nach einem der Ansprüche 1 bis 6 zur Erzeugung einer Zeitbasis.

13. Verwendung nach Anspruch 12, wobei die Zeitbasis in einem intelligenten Akku verwendet wird.

**Claims**

1. Circuit arrangement for generation of an output signal having a constant frequency comprising:

   a controllable oscillator,

   **characterized in that** the circuit arrangement further comprises an integrator circuit (2), wherein the integrator circuit (2) comprises an operational amplifier (OP1) and a capacitance (C1) connected in parallel thereto, **in that** the integrator circuit (2) is provided for integration of an input current, **in that** the integrator circuit (2) serves as a charge storage, **in that** the output of the integrator circuit (2) is provided as an input for the controllable oscillator, wherein the input of the controllable oscillator is connected to the output of the integrator circuit (2), **in that** defined charge packets are drawn off from the charge storage with the output frequency of the controllable oscillator, and **in that** the input of the integrator circuit (2) is connected to a parallel circuit comprising an external current source (6, $R_{ext}$) and a further capacitance (C2) which are separated via a switch (SW3) from the integrator circuit (2) with the frequency (fvco) of the output signal ($U'_{VCO}$).

2. Circuit arrangement according to claim 1, **characterized in that** the circuit arrangement comprises as a controllable oscillator a VCO (1) at the output of which the output signal having a constant frequency ($f_{VCO}$) can be drawn off, and **in that** the VCO (1) is integrated in a (closed-loop) control circuit such that the frequency (fvco) of the output signal of the VCO (1) is only determined by circuit elements (C2, $R_{ext}$) having a low temperature coefficient comprised in the (closed-loop) control circuit.

3. Circuit arrangement according to claim 2, **characterized in that** the input of the VCO (1) is connected to the output of the integrator circuit (2) such that an increase of the output ($U_a$) of the integrator circuit (2) effects a lowering of the frequency (fvco) of the output signal (U'vco) of the VCO (1).

4. Circuit arrangement according to claim 2 or 3, **characterized in that** the output of the VCO (1) is connected to a logic network (3) which, for control of the (closed-loop) control circuit, is connected to switches (SW1, SW3) which separate the external current source (6) and the further capacitance (C2) from the integrator circuit (2).

5. Circuit arrangement according to any of claims 1 to 4, **characterized in that** the further capacitance (C2) is connected on the one hand via a switch (SW1) to the integrator circuit (2) and on the other hand via another switch (SW2) to ground for discharging, wherein the switches (SW1, SW2) are opened and closed alternately.

6. Circuit arrangement according to claim 5, **characterized in that** the switch (SW2) connecting the further capacitance (C2) to ground is also triggered using the logic network (3).

7. Method for generating the output signal having a constant frequency using a circuit arrangement according to any of claims 1 to 6.

8. Method according to claim 7, **characterized in that** as a controllable oscillator the VCO (1) is used at the output of which the output signal having a constant frequency ($f_{VCO}$) can be drawn off, and **in that** the frequency (fvco) is only determined by circuit elements (C2, $R_{ext}$) having a low temperature coefficient which are present in a (closed-loop) control circuit comprising the VCO (1).

**9.** Method according to claim 8, **characterized in that** the output ($U_a$) of the integrator circuit (2) is fed to the input of the VCO (1).

**10.** Method according to claim 9, **characterized in that** the output ($U_a$) of the, integrator circuit (2) is fed to the input of the VCO (1) such that an increase of the output ($U_a$) of the integrator circuit (2) effects a lowering of the frequency (fvco) of the output signal (U'vco) of the VCO (1).

**11.** Method according to any of claims 7-10, **characterized in that** the separation of the integrator circuit (2) from the external current source (6) and the further capacitance (C2) is carried out using a logic network (3) to which the output signal ($U'_{VCO}$) of the VCO (1) is fed.

**12.** Use of the circuit arrangement according to any of claims 1 to 6 for generation of a time basis.

**13.** Use according to claim 12, wherein the time basis is used in an intelligent rechargeable battery.

**Revendications**

**1.** Circuit pour produire un signal de sortie de fréquence constante, qui comprend :

- un oscillateur réglable,

**caractérisé en ce qu'**il comporte également un circuit d'intégration (2), le circuit d'intégration (2) comportant lui-même un amplificateur opérationnel (OP1) et une capacité (C1) montée parallèlement à celui-ci, **en ce que** le circuit d'intégration (2) est prévu pour intégrer un courant d'entrée, **en ce que** le circuit d'intégration (2) sert de mémoire de chargement, **en ce que** la grandeur de sortie du circuit d'intégration (2) est prévue comme grandeur d'entrée pour l'oscillateur réglable, l'entrée de l'oscillateur réglable étant reliée à la sortie du circuit d'intégration (2), **en ce que** des paquets de charge définis avec la fréquence de sortie de l'oscillateur réglable sont prélevés dans la mémoire de charge et **en ce que** l'entrée du circuit d'intégration (2) est reliée à un circuit parallèle composé d'une source de courant extérieure (6, $R_{ext}$) et d'une autre capacité (C2) qui sont séparées du circuit d'intégration (2) par l'intermédiaire d'un commutateur (SW3) de la fréquence ($f_{vco}$) du signal de sortie ($U'_{vco}$).

**2.** Circuit selon la revendication 1, **caractérisé en ce qu'**il comporte comme oscillateur réglable un VCO (1) (oscillateur à commande par tension) à la sortie duquel le signal de sortie de fréquence constante ($f_{vco}$) peut être prélevé, et **en ce que** le VCO (1) est intégré dans un circuit de réglage de telle sorte que la fréquence ($f_{vco}$) du signal de sortie du VCO (1) ne soit définie que par des éléments de circuit (C2, $R_{ext}$) contenus dans le circuit de réglage et présentant des coefficients de température bas.

**3.** Circuit selon la revendication 2, **caractérisé en ce que** l'entrée du VCO (1) est reliée à la sortie du circuit d'intégration (2) de telle sorte qu'une augmentation de la grandeur de sortie ($U_a$) du circuit d'intégration (2) provoque un abaissement de la fréquence ($f_{vco}$) du signal de sortie ($U'_{vco}$) du VCO (1).

**4.** Circuit selon la revendication 2 ou 3, **caractérisé en ce que** la sortie du VCO (1) est reliée à un réseau logique (3) qui, en vue de la commande du circuit de réglage, est relié à des commutateurs (SW1, SW3) qui séparent respectivement la source de courant extérieure (6) et l'autre capacité (C2) du circuit d'intégration (2).

**5.** Circuit selon l'une des revendications 1 à 4, **caractérisé en ce que** l'autre capacité (C2) est reliée d'une part au circuit d'intégration (2) grâce à un commutateur (SW1), et d'autre part à la masse, en vue de son déchargement, par l'intermédiaire d'un autre commutateur (SW2), les commutateurs (SW1, SW2) s'ouvrant et se fermant en alternance.

**6.** Circuit selon la revendication 5, **caractérisé en ce que** le commutateur (SW2) qui relie l'autre capacité (C2) à la masse est commandé lui aussi à l'aide du réseau logique (3).

**7.** Procédé pour produire le signal de sortie de fréquence constante avec un circuit selon l'une des revendications 1 à 6.

8. Procédé selon la revendication 7, **caractérisé en ce qu'**on utilise comme oscillateur réglable le VCO (1) à la sortie duquel le signal de sortie de fréquence constante ($f_{VOC}$) peut être prélevé, et **en ce que** la fréquence ($f_{VCO}$) n'est définie que par les éléments de circuit (C2, $R_{ext}$) avec un coefficient de température bas qui sont prévus dans un circuit de réglage contenant le VCO (1).

9. Procédé selon la revendication 8, **caractérisé en ce que** la grandeur de sortie ($U_a$) du circuit d'intégration (2) est transmise à l'entrée du VCO (1).

10. Procédé selon la revendication 9, **caractérisé en ce que** la grandeur de sortie ($U_a$) du circuit d'intégration (2) est transmise à l'entrée du VCO (1) de telle sorte qu'une augmentation de la grandeur de sortie ($U_a$) du circuit d'intégration (2) provoque un abaissement de la fréquence ($f_{VCO}$) du signal de sortie ($U'_{VCO}$) du VCO (1).

11. Procédé selon l'une des revendications 7 à 10, **caractérisé en ce que** la séparation entre le circuit d'intégration (2) et la source de courant extérieure (6) et l'autre capacité (C2) se fait à l'aide d'un réseau logique (3) auquel est transmis le signal de sortie ($U'_{VCO}$) du VCO (1).

12. Utilisation du circuit selon l'une des revendications 1 à 6 pour produire une base de temps.

13. Utilisation selon la revendication 12, la base de temps étant utilisée dans un accumulateur intelligent.

Fig. 1

Fig. 2

Fig. 3a

Fig. 3b

Fig. 3c

Fig. 3d

Fig. 3e